# EUROPEAN PATENT APPLICATION

(11) **EP 4 814 500 A1**
(43) Date of publication of application: **30.09.2026**
(21) Application number: 24894440.7
(22) Date of filing: 31.10.2024
(51) Int. Cl.: G01R 1/073, G01R 1/067

(54) **PROBE CARD FOR POWER SEMICONDUCTOR FOR HIGH VOLTAGE AND HIGH CURRENT**

(30) Priority: 24.11.2023 KR 20230165807; 04.07.2024 KR 20240088133
(71) Applicant: Belink Co., Ltd., Seongnam-si, Gyeonggi-do 13207 (KR); Han, Koang Duk, Gunpo-si, Gyeonggi-do 15851 (KR); Seo, Jong Chul, Gwangmyeong-si, Gyeonggi-do 14351 (KR)
(72) Inventor: PARK, Sang Young, Icheon-si, Gyeonggi-do 17372 (KR); PARK, In Hyuk, Hwaseong-si, Gyeonggi-do 18494 (KR); HAN, Koang Duk, Gunpo-si, Gyeonggi-do 15851 (KR); SEO, Jong Chul, Gwangmyeong-si, Gyeonggi-do 14351 (KR)
(74) Representative: Schaad, Balass, Menzl & Partner AG
(86) International application number: PCT/KR2024/016931
(87) International publication number: WO 2025/110546

(57) **Abstract**

Disclosed is a probe card for a power semiconductor for high voltage and high current, the probe card being capable of providing uniform pin force and preventing an arc. According to one aspect of the present invention, the probe card for a power semiconductor for high voltage and high current may comprise: a PCB having a through-hole formed on one side thereof so that multiple probe pins pass therethrough and come into contact with a terminal of an object to be tested, thereby forming a test space in which a test is performed; and a pin insert block which is disposed in the through-hole of the PCB and in which a portion of each of the plurality of probe pins is fixed and supported, wherein the plurality of probe pins are fixed to the pin insert block such that each end of the plurality of probe pins coming into contact with the terminal is disposed at the same height.

## Description

### TECHNICAL FIELD

The present invention relates to a probe card for a power semiconductor for high voltage and high current, and more particularly, to a probe card for a power semiconductor for high voltage and high current, the probe card being capable of providing uniform pin force and preventing an arc.

### BACKGROUND

In general, semiconductor products need to undergo tests before shipment, and such tests are essential. Semiconductor products are tested using corresponding probe cards according to characteristics of the products.

A test probe card is an essential component for semiconductor testing, and is used to establish electrical contact between a tester and a semiconductor device being tested. In general, the test probe card comprises an array of probes or pins that contact specific points of the semiconductor device.

Meanwhile, although tests are typically performed at general voltage and current, there are power semiconductors that are tested under high voltage and high current, and there is a probe card for testing such power semiconductors, that is, a probe card for a power semiconductor for high voltage and high current.

In a wafer-level test of a power semiconductor SiC, a currently applied probe card is a cantilever-type probe card.

A cantilever-type probe card for a power semiconductor according to the related art has a problem in that pin force of the probe card is not uniform, thereby causing cracks in a semiconductor wafer pad SiC wafer pad.

In addition, due to strong pin pressure, deep scrub marks may occur, thereby causing damage to a pad layer.

In addition, in the case of a cantilever-type product, it is very difficult to implement the same contact force for all pins assembled on a PCB.

In addition, due to characteristics of the cantilever-type product, probe needles inevitably have a stacked structure, and probes of respective layers have different thicknesses, so that different contact forces are applied during a wafer test.

In the cantilever type according to the related art, as the number of stacked layers increases, the thickness of the probe increases, and probe marks applied when the probe contacts a wafer are also different from each other. Therefore, there is a problem in that pins in a first-layer portion are probed with a strong force, but pins in a third-layer portion may be probed with a weak force.

Conventionally, since it is difficult to match the same contact force for all probes during a test, even when an amount of overdrive is properly applied, a specific pin may be probed with a strong force, thereby causing a crack on a wafer. This problem is a limitation caused by the stacked structure of the cantilever type.

A conventional power semiconductor test is performed under high voltage and high current, and when a power semiconductor is tested, an arc occurs when a probe of a probe card contacts a pad of a wafer due to the flow of high voltage and high current. Unless this problem is solved, there is a problem in that circuits of a wafer layer and pins of the probe card may be burned or damaged.

### DISCLOSURE

### TECHNICAL PROBLEM

The present invention has been made to solve the above-described problems, and an object of the present invention is to provide a probe card for a power semiconductor for high voltage and high current, in which probe needles are respectively attached to individual plates and applied to probing, so that a test can be performed with an overall uniform contact force.

Another object of the present invention is to provide a probe card for a power semiconductor for high voltage and high current, in which probe needles are applied as vertical probes as a whole, thereby eliminating a stacked structure of the needles and allowing a test to be performed with a uniform contact force.

Still another object of the present invention is to provide a probe card for a power semiconductor for high voltage and high current, in which a test portion is placed in an inert gas atmosphere by a flow of gas immediately before probing is performed, thereby fundamentally preventing occurrence of an arc.

The technical problems of the present invention are not limited to those mentioned above, and other problems not mentioned will be clearly understood by those of ordinary skill in the art from the following description.

### TECHNICAL SOLUTION

According to an aspect of the present invention, provided is a probe card for a power semiconductor for high voltage and high current, the probe card including: a PCB having a through-hole formed at one side thereof to define a test space in which a test is performed as a plurality of probe pins pass through the through-hole and contact a terminal of an object to be tested; and
a pin insert block disposed in the through-hole of the PCB and configured to fix and support a portion of each of the plurality of probe pins, wherein the plurality of probe pins are fixed to the pin insert block such that respective end portions of the plurality of probe pins that contact the terminal are disposed at the same height.

According to another aspect of the present invention, provided is a probe card for a power semiconductor for high voltage and high current, the probe card including: a PCB having a through-hole formed at one side thereof to define a test space in which a test is performed as a plurality of probe pins pass through the through-hole and contact a terminal of an object to be tested; a plurality of pin plates disposed in the through-hole of the PCB and configured to fix some of the plurality of probe pins; and a main block configured to accommodate and fix the plurality of pin plates, wherein the plurality of probe pins are fixed to the plurality of pin plates such that respective end portions of the plurality of probe pins that contact the terminal are disposed at the same height.

In this case, the plurality of probe pins may be disposed with the same size and height to have the same contact pin pressure.

In this case, the plurality of probe pins may have a shape bent two or more times.

In this case, end portions of the plurality of probe pins configured to be connected to terminals of the object to be tested may extend vertically.

In this case, a portion of each of the plurality of probe pins may be fixed to the plurality of pin plates or the pin insert block by a soldering process.

In this case, the plurality of probe pins may be MEMS pins, pogo pins, or wire pins.

In this case, the pin insert block may have a gas supply passage formed therein to supply gas to the test space.

In this case, the probe card may further include a moving block installed to surround the test space formed below the pin insert block and configured to move upward and downward so as to be pushed upward by pressure of gas that has passed through the gas supply passage of the pin insert block, is supplied to an outer side of the test space, descends, and is then transferred to the test space.

In this case, the moving block may have an inclined surface formed at a lower end portion thereof so that the moving block is movable upward and downward by pressure of moving gas.

In this case, the main block may have a frame shape, and the plurality of pin plates may be inserted into and fixed to the main block at regular intervals.

In this case, each of the plurality of pin plates may have a plurality of MEMS pins vertically fixed to a lower end portion thereof by soldering.

In this case, the main block may have a seating groove formed therein, and both ends of each of the plurality of pin plates may be inserted into and fixed to the seating groove.

In this case, each of the plurality of pin plates may have a rounded cutout formed in a side surface thereof so that gas can pass therethrough.

In this case, the main block may be provided with a gas inlet/outlet in a direction perpendicular to the plurality of pin plates to allow gas to be supplied under pressure into and discharged from the main block.

### ADVANTAGEOUS EFFECT

According to the above configuration, in the probe card for a power semiconductor for high voltage and high current according to an aspect of the present invention, probe needles are respectively attached to individual plates and applied to probing, so that a test can be performed with an overall uniform contact force.

In the probe card for a power semiconductor for high voltage and high current according to another aspect of the present invention, the probe needles are applied as vertical probes as a whole, thereby eliminating a stacked structure of the needles and allowing a test to be performed with a uniform contact force.

In the probe card for a power semiconductor for high voltage and high current according to still another aspect of the present invention, a test portion is placed in an inert gas atmosphere by a flow of gas immediately before probing is performed, thereby fundamentally preventing occurrence of an arc.

Advantageous effects of the present invention are not limited to the above-described effects, and it should be understood that the present invention includes all effects that can be inferred from the configurations described in the detailed description or claims.

### BRIEF DESCRIPTION OF THE DRAWINGS

FIG. 1 is a plan view of a probe card for a power semiconductor for high voltage and high current according to an embodiment of the present invention.
FIG. 2 is an exploded perspective view of the probe card for a power semiconductor for high voltage and high current according to an embodiment of the present invention.
FIG. 3 is an enlarged view of a main part of FIG. 2.
FIG. 4 is a plan view of the probe card for a power semiconductor for high voltage and high current according to an embodiment of the present invention, with a stiffener omitted.
FIG. 5 is a partially cutaway perspective view of the probe card for a power semiconductor for high voltage and high current according to an embodiment of the present invention.
FIG. 6 is an enlarged view of a main part of FIG. 5.
FIG. 7 is a cross-sectional view taken along a longitudinal direction of the probe card for a power semiconductor for high voltage and high current according to an embodiment of the present invention.
FIG. 8 is a cross-sectional view taken in a direction perpendicular to the longitudinal direction of the probe card for a power semiconductor for high voltage and high current according to an embodiment of the present invention.
FIG. 9 is a partially cutaway perspective view of a pin insert block and a moving block, which are some components of the probe card for a power semiconductor for high voltage and high current according to an embodiment of the present invention.
FIG. 10 is an operational view before a moving block, which is a component of the probe card for a power semiconductor for high voltage and high current according to an embodiment of the present invention, is raised.
FIG. 11 is an operational view after the moving block, which is a component of the probe card for a power semiconductor for high voltage and high current according to an embodiment of the present invention, is raised.
FIG. 12 is a configuration diagram of a pin plate and a probe needle, which are some components of a probe card for a power semiconductor for high voltage and high current according to another embodiment of the present invention.
FIG. 13 is a perspective view of a main block and a pin plate, which are some components of a probe card for a power semiconductor for high voltage and high current according to another embodiment of the present invention.
FIG. 14 is an operational view after the main block and the pin plate according to the embodiment illustrated in FIG. 13 are coupled.
FIG. 15 is a view illustrating another embodiment of the pin plate as another embodiment of the embodiment illustrated in FIG. 13.

### MODES OF THE INVENTION

Hereinafter, embodiments of the present invention will be described in detail with reference to the accompanying drawings so that those of ordinary skill in the art can readily implement the present invention. The present invention may be embodied in many different forms and is not limited to the embodiments set forth herein. Portions irrelevant to the description have been omitted for clarity of explanation of the present invention, and throughout the specification, the same reference numerals are used to denote identical or similar components.

The words and terms used in the present specification and claims should not be interpreted as being limited to their ordinary or dictionary meanings, but should be construed as having meanings and concepts consistent with the technical spirit of the present invention, in accordance with the principle that an inventor may define terms and concepts to best describe their invention.

Accordingly, the embodiments described in the present specification and the configurations shown in the drawings correspond to preferred embodiments of the present invention, and do not represent all the technical spirit of the present invention, so the configurations may have various examples of equivalent and modification that can replace them at the time of filing the present invention.

It should be understood that the terms "comprise or include" or "have" or the like when used in this specification, are intended to describe the presence of stated features, numbers, steps, operations, elements, components and/or a combination thereof but not preclude the possibility of the presence or addition of one or more other features, numbers, steps, operations, elements, components, or a combination thereof.

The presence of an element in/on "front", "rear", "upper or above or top" or "lower or below or bottom" of another element includes not only being disposed in/on "front", "rear", "upper or above or top" or "lower or below or bottom" directly in contact with other elements, but also cases in which another element being disposed in the middle, unless otherwise specified. In addition, unless otherwise specified, that an element is "connected" to another element includes not only direct connection to each other but also indirect connection to each other.

Hereinafter, a probe card 1 for a power semiconductor for high voltage and high current according to an embodiment of the present invention will be described with reference to the drawings.

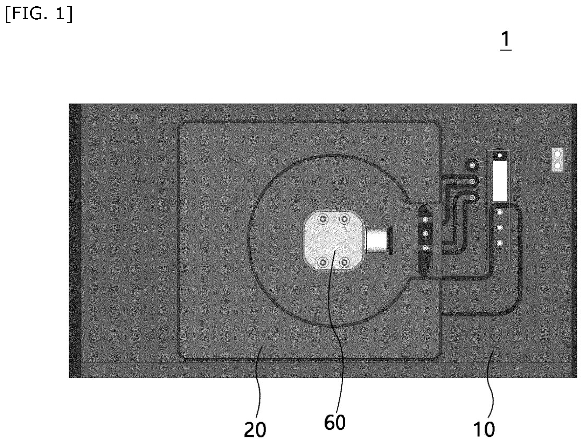

Referring to FIGS. 1 to 11, the probe card 1 for a power semiconductor for high voltage and high current according to an embodiment of the present invention may include a PCB 10, a pin insert block 30, a plurality of probe pins 32, a stiffener 20, a cover block 40, a moving block 50, and a fitting block 60.

Referring to FIGS. 1 to 7, the PCB 10 may have, on one side thereof, a through-hole formed to define a test space in which a test is performed as the plurality of probe pins 32 pass through the through-hole and contact terminals of an object to be tested.

In this case, the PCB 10 may be connected to a power source and may provide electric current to the plurality of probe pins 32 to test the object to be tested.

In this case, the object to be tested may be positioned at a position of the through-hole of the PCB 10, and the test may be performed as the probe pins 32 pass through the through-hole and contact the object to be tested.

In this case, the PCB 10 may have a plate shape and may not support other components due to material properties thereof, and instead, the stiffener 20 may support the PCB 10.

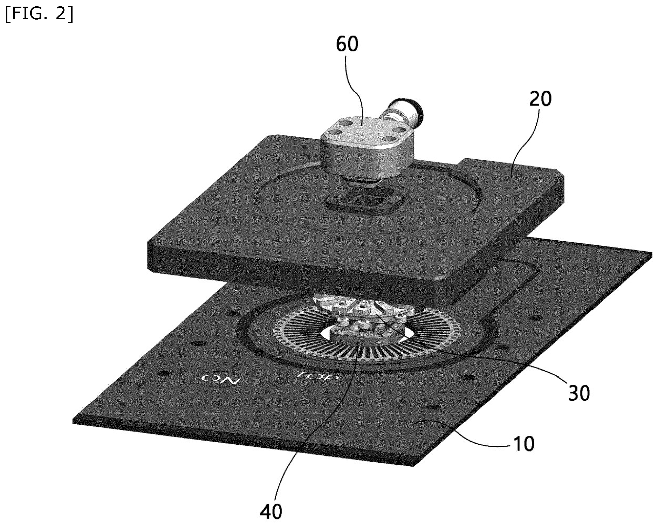

Referring to FIGS. 2 to 4, the pin insert block 30 may be disposed in the through-hole of the PCB 10, and a portion of each of the plurality of probe pins 32 may be fixed and supported by the pin insert block 30.

In this case, the plurality of probe pins 32 may be fixed to the pin insert block 30 such that respective end portions thereof that contact the terminals are disposed at the same height.

In this case, the pin insert block 30 may have a plurality of holes through which the probe pins 32 pass, and the probe pins 32 may pass through the holes and then be fixed by soldering or the like.

In this case, the plurality of probe pins 32 may also be configured such that a pin plate is mounted on the pin insert block 30 and the plurality of probe pins 32 are fixed to the pin plate by soldering.

In this case, the plurality of probe pins 32 may be disposed with the same size and height to have the same contact pin pressure.

In this case, the plurality of probe pins 32 may have a shape bent two or more times. In this embodiment, the plurality of probe pins 32 have a shape bent twice, lower end portions to be connected to the terminals are formed vertically, portions above the lower end portions are bent to have an angle, and the probe pins 32 may be bent again and fixed while vertically passing through the holes of the pin insert block 30. Of course, in this case, an upper end portion of each of the probe pins 32 may then be electrically connected to the PCB 10.

In this case, a portion of each of the plurality of probe pins 32 may be fixed to the plurality of pin plates or the pin insert block 30 by a soldering process.

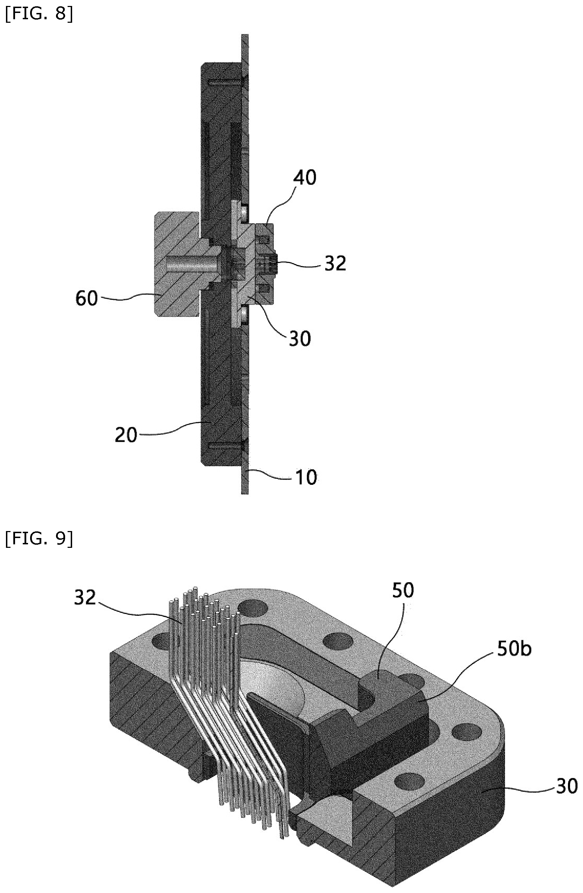

In this case, since the plurality of probe pins 32 are fixed in a state of being bent twice, referring to FIG. 9, each of the plurality of probe pins 32 may include upper and lower vertical portions and one inclined portion connecting the upper and lower vertical portions.

In this case, the pin insert block 30 may have a gas supply passage 30a formed to supply gas to the test space. An inert gas such as nitrogen gas may be provided through the gas supply passage 30a. In this way, occurrence of an arc can be prevented in advance by providing an inert gas atmosphere to the test space in which the plurality of probe pins 32 and the terminals of the object to be tested are connected to each other.

The stiffener 20 may be finally fastened and fixed to the PCB 10, and other blocks having substantial weight, including the pin insert block 30, may be fastened and fixed to the stiffener 20. The stiffener 20 may also serve as a frame that supports other components and, at the same time, prevents deformation to maintain a shape thereof.

In this case, the pin insert block 30 may be fastened to and supported by the stiffener 20 from below, and the cover block 40 may be fastened to and supported by the pin insert block 30 below the pin insert block 30. In addition, the cover block 40 may have an elevation groove formed therein, and the moving block 50 may be inserted into the elevation groove to be movable upward and downward.

Accordingly, the stiffener 20 may support the pin insert block 30, the cover block 40, the moving block 50, and even the fitting block 60.

Referring to FIGS. 2 to 9, the cover block 40 may have a through-hole formed in a center thereof so that the plurality of probe pins 32 can pass therethrough.

In this case, the cover block 40 may be fastened and fixed to the pin insert block 30. Accordingly, the cover block 40 may be supported by the stiffener 20.

In this case, as described above, the cover block 40 is disposed closest to a wafer, which is the object to be tested, and has the elevation groove formed therein to accommodate the moving block 50 that moves upward and downward.

In this case, the moving block 50, which is inserted into the elevation groove of the cover block 40 and guided to move upward and downward, has a portion spaced apart from the elevation groove so that gas can pass through the spaced portion. Of course, the portion through which the gas passes is disposed below the gas supply passage 30a of the pin insert block 30. Accordingly, gas supplied to a fitting member 61 and the fitting block 60 flows into an upper portion of the pin insert block 30 and then passes through the gas supply passage 30a to move downward. Then, the gas moves downward toward an outer side of the moving block 50 disposed below the gas supply passage 30a, and may be discharged to the outside through the test space.

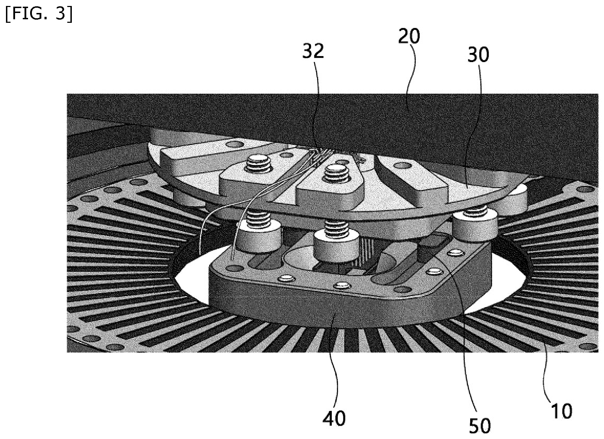

Referring to FIGS. 3 and 9 to 11, the moving block 50 may be installed to surround the test space formed below the pin insert block 30, and may be moved upward and downward so as to be pushed upward by pressure of gas that has passed through the gas supply passage 30a of the pin insert block 30, is supplied to an outer side of the test space, moves downward, and is then transferred to the test space.

In this case, the moving block 50 may have an inclined surface 50a formed at a lower end portion thereof so that the moving block 50 can move upward and downward by pressure of moving gas.

In this case, the moving block 50 may have an inclined surface 50b formed at an upper end portion thereof so that the moving gas can be guided outward.

Accordingly, gas provided to the outer side of the moving block 50 moves to the lower end portion and then moves to the test space. In this case, by the pressure of the gas moving from the outside to the inside, that is, to the test space, at the lower end portion and by the inclined surface, the moving block 50 receives upward pressure in proportion to the magnitude of the pressure. As a result, when the pressure of the gas is equal to or greater than a predetermined pressure, the moving block 50 rises, and when the pressure is less than the predetermined pressure, the moving block 50 descends by its own weight. Consequently, the inclined surface structure of the moving block 50 can improve the flow of the supplied gas.

Referring to FIGS. 1 to 11, the fitting block 60 may be fastened and fixed to the stiffener 20 and may be positioned on an upper side of the pin insert block 30.

In this case, the fitting block 60 may include the fitting member 61, and a fitting pipe for supplying gas may be connected to the fitting member 61.

In this case, the fitting block 60 may have a horizontal flow path 60a in fluid communication with the fitting member 61 and a vertical flow path 60b in fluid communication with an end portion of the horizontal flow path 60a.

In this case, gas that has passed through the horizontal flow path 60a and the vertical flow path 60b may be supplied to an upper surface of the pin insert block 30. The gas supplied to the upper surface of the pin insert block 30 moves to the outside of the moving block 50 through the gas supply passage 30a, as described above.

Referring to FIG. 1, a plan view of the probe card 1 for a power semiconductor for high voltage and high current according to an embodiment of the present invention is illustrated.

In the illustrated embodiment, the stiffener 20 is fixed to an upper side of the PCB 10, a through-hole is formed in a center of the stiffener 20, and the fitting block 60 is assembled to and supported on an upper side of the through-hole.

In this case, the fitting member 61 is provided on one side of the fitting block 60, and may be connected thereto so that gas can be supplied from the outside.

Referring to FIG. 2, an exploded perspective view of the probe card 1 for a power semiconductor for high voltage and high current according to an embodiment of the present invention is illustrated.

In the illustrated embodiment, the fitting block 60, the stiffener 20, the pin insert block 30, and the cover block 40 may be assembled from above.

In this case, the fitting block 60 may be fastened from an upper side of the through-hole of the stiffener 20 and fixed to the stiffener 20.

In this case, the pin insert block 30 may be fastened and fixed to a lower side of the through-hole of the stiffener 20.

In this case, the cover block 40 may be fastened and fixed to a lower side of the pin insert block 30.

In this case, the stiffener 20 may be fastened to and fixed with the PCB 10 as described above. Since the PCB 10 has weak strength for supporting and accommodating all blocks due to material properties of the PCB 10, the stiffener 20 may be introduced to serve as a frame.

Referring to FIG. 3, an enlarged view of a main part of FIG. 2 is illustrated.

In the illustrated embodiment, the pin insert block 30 may be fastened and fixed to a lower portion of the stiffener 20 by a plurality of bolts.

In this case, the cover block 40 may also be fastened and fixed to a lower portion of the pin insert block 30 by a plurality of bolts.

In this case, the moving block 50 is inserted into the elevation groove of the cover block 40 so as to be guided to move upward and downward. Accordingly, the moving block 50 can move upward and downward only in the vertical direction along guidance of the elevation groove, that is, only in a predetermined arrangement.

In this case, the plurality of probe pins 32 may be installed through the holes of the pin insert block 30.

In this case, the plurality of probe pins 32 may have a shape bent twice, and may include vertical portions at upper and lower end portions and an inclined portion therebetween.

In this case, the vertical portions of the plurality of probe pins 32 may be completely vertical or may have a slight inclination. Of course, the vertical portions may have a large angular difference from the inclined portion.

In this case, lower end portions of the plurality of probe pins 32 are positioned slightly lower than a lower end portion of the through-hole of the cover block 40, and are electrically connected to terminals of an object to be tested at that position to perform a test. Accordingly, that portion defines the test space.

In this case, gas is supplied to the test space through an outer side of the moving block 50, so that an arc that may occur upon connection can be prevented in advance.

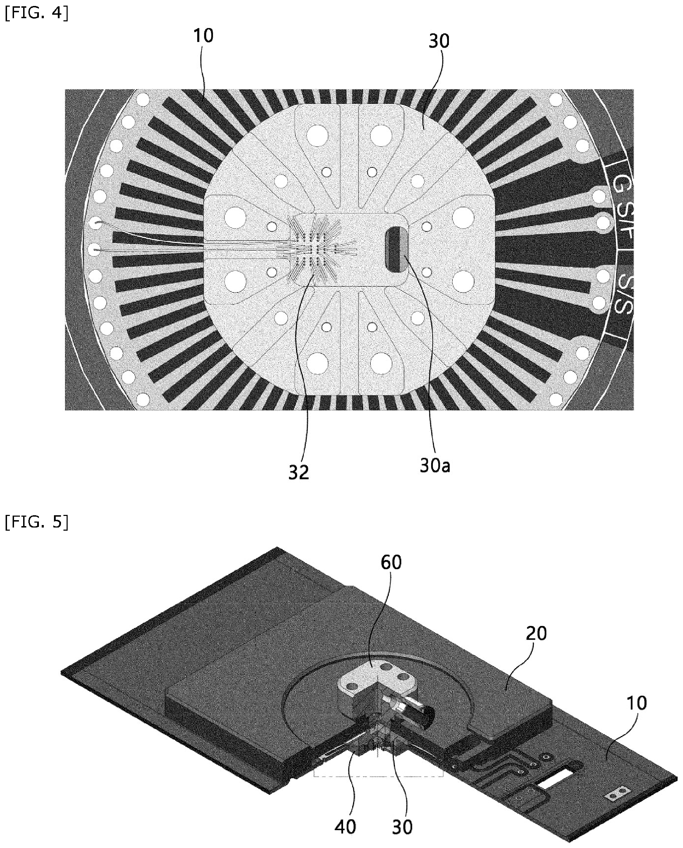

Referring to FIG. 4, a plan view of the probe card 1 for a power semiconductor for high voltage and high current according to an embodiment of the present invention, with the stiffener 20 omitted, is illustrated.

In the illustrated embodiment, the pin insert block 30 is positioned on an upper side of the PCB 10, a plurality of probe pins are installed through respective through-holes, and each of the probe pins 32 is connected to the PCB 10 so that a test can be performed.

In this case, the gas supply passage 30a through which gas is supplied is formed in a hole shape at one side of the pin insert block 30. Gas supplied from the fitting block 60 may pass through the gas supply passage 30a and be supplied to an outer side of the moving block 50 inserted into the elevation groove of the cover block 40.

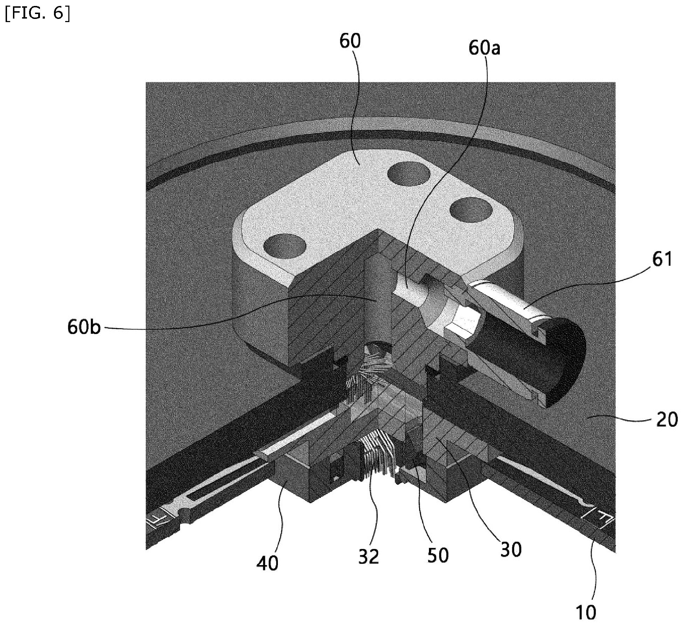

Referring to FIG. 5, a partially cutaway perspective view of the probe card 1 for a power semiconductor for high voltage and high current according to an embodiment of the present invention is illustrated, and referring to FIG. 6, an enlarged view of a main part of FIG. 5 is illustrated.

In the illustrated embodiment, the fitting block 60, the stiffener 20, the pin insert block 30, and the cover block 40 may be sequentially assembled from above, and may be fixed and supported by the stiffener 20.

In this case, the PCB 10 is disposed at a height similar to that of the pin insert block 30. A portion of the pin insert block 30 may be installed in close contact with an upper surface of the PCB 10.

In this case, a lower end portion of the probe pin 32 passing through the pin insert block 30 is positioned near the through-hole of the cover block 40, which is the test space, and is connected to a terminal of the object to be tested.

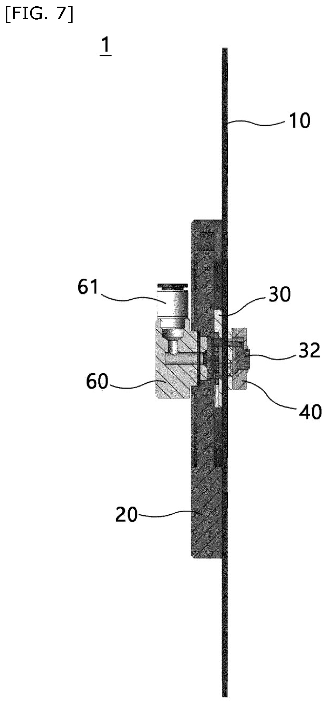

Referring to FIG. 7, a cross-sectional view taken along a longitudinal direction of the probe card 1 for a power semiconductor for high voltage and high current according to an embodiment of the present invention is illustrated, and referring to FIG. 8, a cross-sectional view taken in a direction perpendicular to the longitudinal direction of the probe card 1 for a power semiconductor for high voltage and high current according to an embodiment of the present invention is illustrated.

In the illustrated embodiment, when gas is supplied through the fitting member 61, the gas moves downward through the horizontal flow path and the vertical flow path of the fitting block 60. The gas passes through the gas supply passage 30a of the pin insert block 30, is supplied to an outer side of the moving block 50, is supplied to the test space through the lower end portion of the moving block 50, and may then be discharged.

In this case, the plurality of probe pins 32 are installed in the pin insert block 30, and the lower end portions of the probe pins 32 are positioned in the test space and connected to terminals of the object to be tested.

In this case, the lower end portions of the plurality of probe pins 32 are connected to the terminals of the object to be tested, and the lower end portions connected thereto are connected to the terminals in a substantially vertical orientation.

In this case, since each probe pin 32 is disposed at substantially the same position as the corresponding terminal and also has a similar shape and thickness, each probe pin 32 can be connected to the terminal with the same pin pressure, thereby implementing uniform contact force.

Referring to FIG. 9, a partially cutaway perspective view of the pin insert block 30 and the moving block 50, which are some components of the probe card 1 for a power semiconductor for high voltage and high current according to an embodiment of the present invention, is illustrated.

In the illustrated embodiment, the moving block 50 is inserted into the elevation groove of the cover block 40 and can move upward and downward according to gas pressure.

In this case, inclined surfaces 50a and 50b are formed on one upper side and one lower side of the moving block 50, and gas supplied to the outer side of the moving block 50 by guidance of the upper inclined surface 50b is supplied to the test space along the lower inclined surface 50a, so that the moving block 50 moves upward and downward according to the degree of gas pressure.

In this case, a portion of the moving block 50 is inserted to fill the elevation groove, and a portion in which the inclined surfaces 50a and 50b are formed is installed to have a space between the portion and the cover block 40 so that gas can pass therethrough.

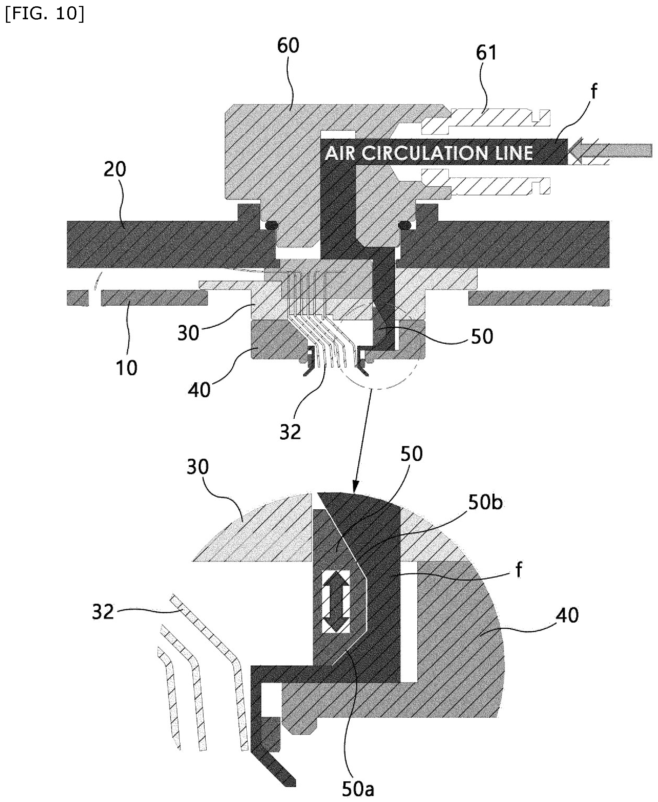

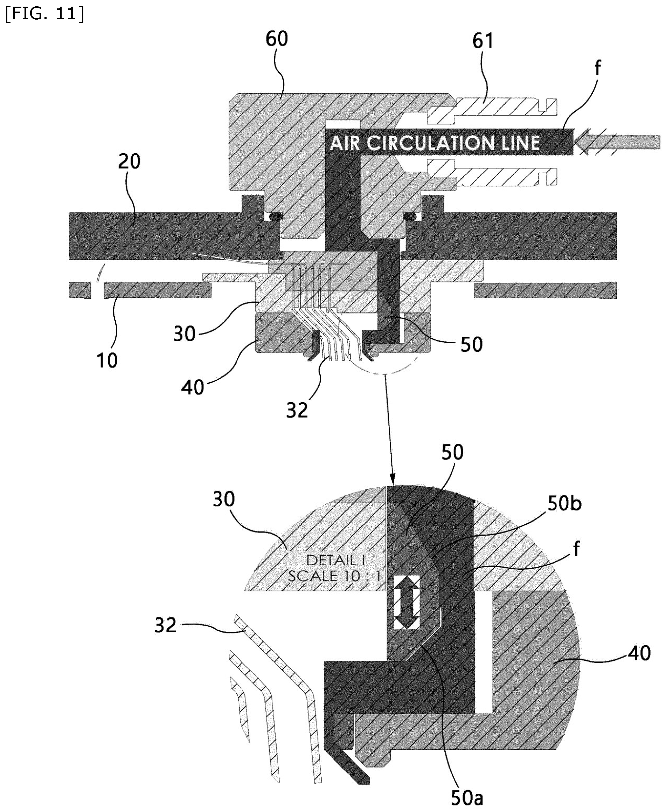

Referring to FIG. 10, an operational view before the moving block 50, which is a component of the probe card 1 for a power semiconductor for high voltage and high current according to an embodiment of the present invention, is raised is illustrated, and referring to FIG. 11, an operational view after the moving block 50, which is a component of the probe card 1 for a power semiconductor for high voltage and high current according to an embodiment of the present invention, is raised is illustrated.

In the illustrated embodiment, referring to FIG. 10, gas may be supplied through the fitting member 61. The gas passes through the horizontal flow path 60a and the vertical flow path 60b of the fitting block 60 and is provided to an upper portion of the pin insert block 30. The gas is provided downward toward the cover block 40 and the moving block 50 through the gas supply passage 30a of the pin insert block 30. The gas provided to the outer side of the moving block 50 applies pressure to the inclined surface 50a of the moving block 50 by gas pressure thereof, so that the moving block 50 rises according to the magnitude of the pressure, and may pass through a separation space between the lower end portion of the moving block 50 and the cover block 40, be supplied to the test space in which the lower end portions of the plurality of probe pins 32 are disposed, and then be discharged to the outside.

In the illustrated embodiment, referring to FIG. 11, as the supply pressure of the gas increases, the moving block 50 rises to a higher position, and a larger amount of gas may be supplied to the test space.

Accordingly, an elevation height of the moving block 50 may vary according to the pressure of the supplied gas.

By increasing the pressure of the gas supplied in this way at the moment when the probe pins 32 are connected to the terminals, the test space can be filled with an inert gas atmosphere, and an arc that may occur at that moment can be prevented. As a result, burning and damage of the probe pins 32 or components due to occurrence of an arc can be prevented.

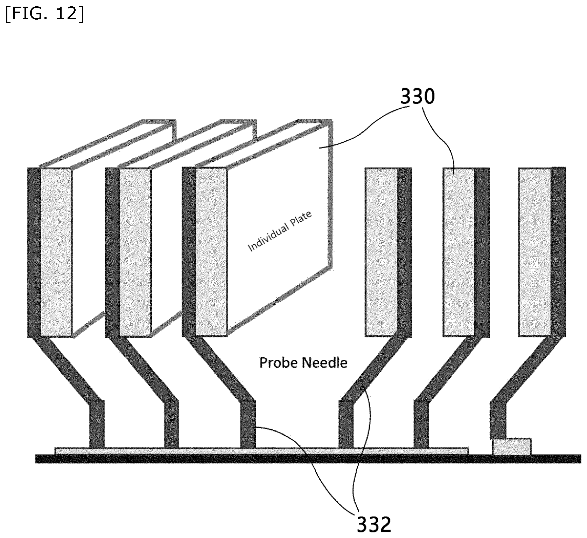

Meanwhile, referring to FIG. 12, a configuration diagram of the pin plate 330 and a probe needle, which are some components of the probe card 1 for a power semiconductor for high voltage and high current according to another embodiment of the present invention, is illustrated.

In the illustrated embodiment, at least one or more probe pins 332 bent twice may be fixed to the pin plate 330 to manufacture the pin plate 330 having the probe pins 332.

In this case, a portion of each probe pin 332 may be fixed to the pin plate 330 by a soldering method, and portions of the probe pins 332 connected to the terminals may be disposed at substantially the same height.

In this case, since the probe pins 332 are manufactured to have the same shape, size, and thickness, a test may be performed with uniform pin pressure when the probe pins 332 are connected to the terminals.

In this case, the pin plates 330 may be installed to be respectively fixed through a separate block such as the pin insert block 30.

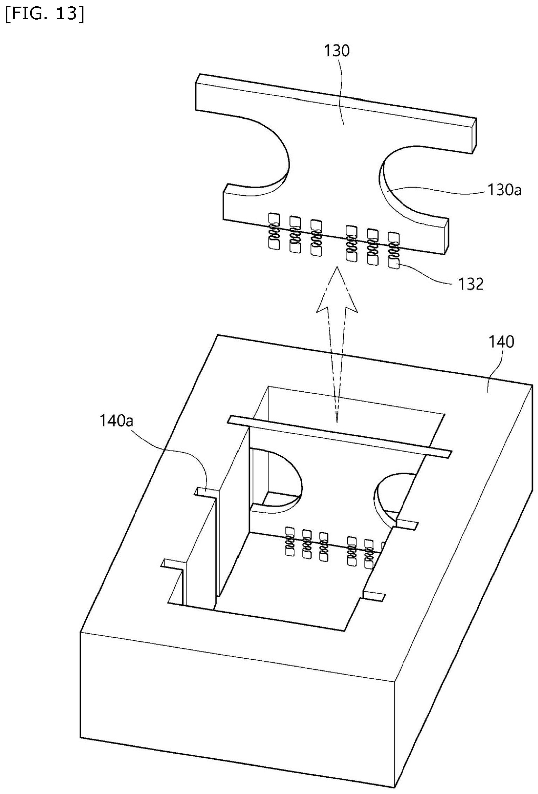

Meanwhile, a probe card 1 for a power semiconductor for high voltage and high current according to another embodiment of the present invention is illustrated in FIGS. 13 to 15.

The probe card 1 for a power semiconductor for high voltage and high current may include: the PCB 10 having, on one side thereof, a through-hole formed to define a test space in which a test is performed as a plurality of probe pins pass through the through-hole and contact terminals of an object to be tested; a plurality of pin plates 130 disposed in the through-hole of the PCB 10 and to which some of the plurality of probe pins are fixed; and a main block 140 in which the plurality of pin plates 130 are accommodated and fixed.

Here, the plurality of probe pins may be fixed to the plurality of pin plates 130 such that respective end portions thereof that contact the terminals are disposed at the same height.

In this case, the plurality of probe pins may be disposed with the same size and height to have the same contact pin pressure.

In this case, the plurality of probe pins may have the shape bent two or more times as described above.

In this case, end portions of the plurality of probe pins configured to be connected to terminals of the object to be tested may extend vertically.

In this case, a portion of each of the plurality of probe pins may be fixed to the plurality of pin plates 130 by a soldering process.

In this case, the plurality of probe pins may be MEMS pins 132, pogo pins, or wire pins.

In this case, the main block 140 may have a frame shape, and the plurality of pin plates 130 may be inserted into and fixed to the main block 140 at regular intervals.

In this case, a plurality of MEMS pins 132 may be vertically fixed by soldering to a lower end portion of each of the plurality of pin plates 130.

In this case, the main block 140 may have a seating groove 140a formed therein, and both ends of each of the plurality of pin plates 130 may be inserted into and fixed to the seating groove 140a.

In this case, each of the plurality of pin plates 130 may have a rounded cutout 130a formed in a side surface thereof so that gas can pass therethrough.

In this case, the main block 140 may be provided with a gas inlet/outlet 141 in a direction perpendicular to the plurality of pin plates 130 to allow gas to be supplied under pressure into and discharged from the main block 140.

Referring to FIG. 13, a perspective view of the main block 140 and the pin plate 130, which are some components of the probe card 1 for a power semiconductor for high voltage and high current according to another embodiment of the present invention, is illustrated.

In the illustrated embodiment, the main block 140 has a frame shape with a through portion in a center thereof, and has the seating groove 140a formed therein so that the pin plate 130 can be inserted and seated. Accordingly, the pin plate 130 can be inserted into and fixed to the seating grooves 140a on both sides.

In this case, the main block 140 may be installed to be disposed and fixed in the through-hole of the PCB, and since the MEMS pins 132 are disposed at a lower end portion of the pin plate 130 installed in the main block 140, that portion defines the test space.

In this case, in a state in which the pin plate 130 is assembled to and fixed to the main block 140, gas may be supplied so that an inert gas atmosphere can be formed inside the main block 140, as in the above-described embodiment.

In this case, rounded cutouts 130a are formed on both sides of the pin plate 130 so that gas can flow through the rounded cutouts 130a.

In this case, an upper end portion of the pin plate 130 is formed to be longer than a lower end portion thereof so as to be fully inserted into the seating groove 140a.

In this case, a plurality of MEMS pins 132 having the same height are fixed to the lower end portion of the pin plate 130 by a soldering method. Accordingly, the MEMS pins 132 can be connected to the terminals with the same pin pressure.

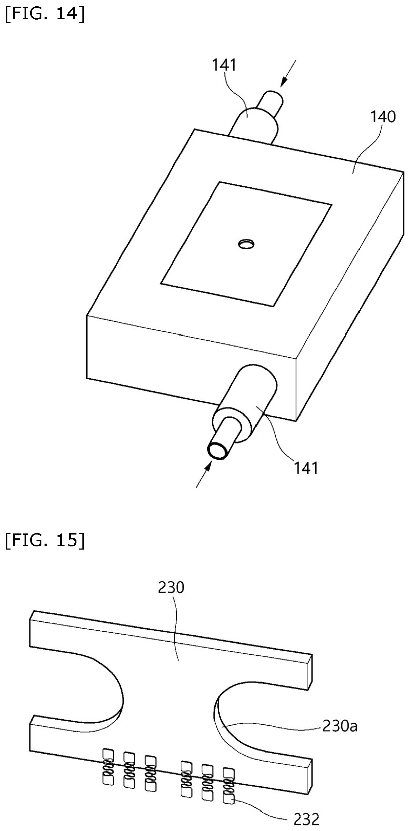

Referring to FIG. 14, an operational view after the main block 140 and the pin plate 130 according to the embodiment illustrated in FIG. 13 are coupled is illustrated.

In the illustrated embodiment, gas inlets/outlets 141 are formed so that gas can be supplied to both sides, and gas may be supplied to the inlets/outlets 141 on both sides at a predetermined pressure. The supplied gas may move to the lower test space and then be discharged to the outside.

In this case, since the rounded cutout 130a is formed in each pin plate 130, a test can be performed in the test space under a gas atmosphere having a predetermined pressure, and occurrence of an arc can be prevented by the inert gas atmosphere even at the moment when the MEMS pins 132 are connected to the terminals.

Referring to FIG. 15, another embodiment of the pin plate 230 is illustrated as another embodiment of the embodiment illustrated in FIG. 13.

In the illustrated embodiment, the configuration is the same in that a plurality of MEMS pins 232 are installed at a lower end portion of the pin plate 230 and the rounded cutouts 230a are formed, but the upper end and the lower end are formed to have the same length. When manufactured in this manner, it may be difficult to respond to occurrence of clearance in the seating groove during assembly, but there is an advantage in that assembly can be performed very firmly.

Although embodiments of the present invention have been described, the spirit of the present invention is not limited to the embodiments set forth herein. Those of ordinary skill in the art who understand the spirit of the present invention may easily propose other embodiments through supplement, change, removal, addition, etc. of elements within the same scope of spirit, but the embodiments will be also within the scope of the present invention.

### INDUSTRIAL APPLICABILITY

The present invention can be applied to a probe card for testing a power semiconductor for high voltage and high current.

## Claims

1. A probe card for a power semiconductor for high voltage and high current, comprising:
a PCB having a through-hole formed at one side thereof to define a test space in which a test is performed as a plurality of probe pins pass through the through-hole and contact a terminal of an object to be tested; and
a pin insert block disposed in the through-hole of the PCB and configured to fix and support a portion of each of the plurality of probe pins,
wherein the plurality of probe pins are fixed to the pin insert block such that respective end portions of the plurality of probe pins that contact the terminal are disposed at the same height.

2. A probe card for a power semiconductor for high voltage and high current, comprising:
a PCB having a through-hole formed at one side thereof to define a test space in which a test is performed as a plurality of probe pins pass through the through-hole and contact a terminal of an object to be tested;
a plurality of pin plates disposed in the through-hole of the PCB and configured to fix some of the plurality of probe pins; and
a main block configured to accommodate and fix the plurality of pin plates,
wherein the plurality of probe pins are fixed to the plurality of pin plates such that respective end portions of the plurality of probe pins that contact the terminal are disposed at the same height.

3. The probe card of claim 1 or 2, wherein the plurality of probe pins are disposed with the same size and height to have the same contact pin pressure.

4. The probe card of claim 1 or 2, wherein the plurality of probe pins have a shape bent two or more times.

5. The probe card of claim 1 or 2, wherein each of the plurality of probe pins has an end portion connected to the terminal of the object to be tested, the end portion extending vertically.

6. The probe card of claim 1, wherein a portion of each of the plurality of probe pins is fixed to the pin insert block by a soldering process.

7. The probe card of claim 1 or 2, wherein the plurality of probe pins are MEMS pins, pogo pins, or wire pins.

8. The probe card of claim 1, wherein the pin insert block has a gas supply passage formed therein to supply gas to the test space.

9. The probe card of claim 8, further comprising:
a moving block installed to surround the test space formed below the pin insert block and configured to move upward and downward so as to be pushed upward by pressure of gas that has passed through the gas supply passage of the pin insert block, is supplied to an outer side of the test space, descends, and is then transferred to the test space.

10. The probe card of claim 9, wherein the moving block has an inclined surface formed at a lower end portion thereof so that the moving block is movable upward and downward by pressure of moving gas.

11. The probe card of claim 2, wherein the main block has a frame shape, and the plurality of pin plates are inserted into and fixed to the main block at regular intervals.

12. The probe card of claim 11, wherein each of the plurality of pin plates has a plurality of MEMS pins vertically fixed to a lower end portion thereof by soldering.

13. The probe card of claim 11, wherein the main block has a seating groove formed therein, and both ends of each of the plurality of pin plates are inserted into and fixed to the seating groove.

14. The probe card of claim 11, wherein each of the plurality of pin plates has a rounded cutout formed in a side surface thereof so that gas can pass therethrough.

15. The probe card of claim 11, wherein the main block is provided with a gas inlet/outlet in a direction perpendicular to the plurality of pin plates to allow gas to be supplied under pressure into and discharged from the main block.
